# EUROPEAN PATENT SPECIFICATION

(11) **EP 0 162 677 B1**
(45) Date of publication and mention of the grant of the patent: **22.09.1993**
(21) Application number: 85303488.2
(22) Date of filing: 17.05.1985
(51) Int. Cl.: H01L 21/00, H01L 21/82, H01L 27/15

(54) **Method of forming a semiconductor device comprising an optical and an electronic element**
Verfahren zur Herstellung einer Halbleitervorrichtung mit einem optischen und einem elektronischen Bauelement
Méthode de formation d'un dispositif semi-conducteur comprenant un élément optique et un élément électronique

(30) Priority: 18.05.1984 JP 98542/84; 18.05.1984 JP 98543/84; 18.05.1984 JP 98544/84; 19.05.1984 JP 99691/84; 29.06.1984 JP 133298/84
(43) Date of publication of application: 27.11.1985
(73) Proprietor: FUJITSU LIMITED, Kawasaki-shi, Kanagawa 211 (JP)
(72) Inventor: Wada, Osamu, Isehara-shi Kanagawa 259-11 (JP); Sanada, Tatsuyuki, Yokohama-shi Kanagawa 227 (JP); Miura, Shuichi, Atsugi-shi Kanagawa 243 (JP); Machida, Hideki, Atsugi-shi Kanagawa 243 (JP); Yamakoshi, Shigenobu, Ebina-shi Kanagawa 243-04 (JP); Sakurai, Teruo, Sagamihara-shi Kanagawa 229 (JP)
(74) Representative: Fane, Christopher Robin King

(56) References cited:
- APPLIED PHYSICS LETTERS, vol. 44, no. 3, 1st February 1984, pages 325-327, American Institute of Physics, New York, US; T. SANADA et al.: "Monolithic integration of an AlGaAs/GaAs multiquantum well laser and GaAs metal-semiconductor field-effect transistors on a semi-insulating GaAs substrate by molecular beam epitaxy"
- ELECTRONICS LETTERS, vol. 19, no. 24, November 1983, pages 1020-1021, London, GB; S. YAMAKOSHI et al.: "AlGaAs/GaAs multiquantum-well (MQW) laser applied to monolithic integration with fet driver"
- IEEE GaAs INTEGRATED CIRCUIT SYMPOSIUM, Technical Digest 1983, Phoenix, 25th - 27th October 1983, pages 44-47, IEEE; M.E. KIM et al.: "GaA1As/GaAs integrated optoelectronic transmitter using selective MOCVD epitaxy and planar ion implantation"
- ELECTRONICS LETTERS, vol. 20, no. 22, 25th October 1984, pages 936-937, Staines, GB; O. WADA et al.: "Improving performance of AlGaAs/GaAs monolithic laser/FET by GRIN-SCH quantum-well laser"
- APPLIED PHYSICS LETTERS, vol. 46, no. 4, February 1985, pages 389-391, American Institute of Physics, New York, US; S. MIURA et al.: "Monolithic integration of a pin photodiode and a field-effect transistor using a new fabrication technique - graded step process"
- APPLIED PHYSICS LETTERS, vol. 46, no. 3, 1st February 1985, pages 226-228, American Institute of Physics, New York, US; T. SANADA et al.: "Monolithic integration of a low threshold current quantum well laser and a driver circuit on a GaAs substrate"

## Description

The present invention relates to the production of semiconductor devices.

Recent advances in the technologies of crystal growth and device production have made it possible to combine optical and electronic elements into a single chip. Such an optoelectronic integrated circuit (OEIC) device is not only smaller and easier to use in various systems but speedier, more reliable, and less noisy than hybridized discrete devices.

A particularly attractive and important OEIC device is one in which an optical semiconductor element, for example a laser diode or photo diode (PD), is monolithically integrated with a field effect transistor (FET) driver. Such an OEIC device is disclosed in Applied Physics Letters, 44(3), 1 February, 1984, at pages 325-327, in a paper entitled "Monolithic integration of an AlGaAs/GaAs multiquantum well laser and GaAs metal-semiconductor field-effect transistors on a semi-insulating GaAs substrate by molecular beam epitaxy".

In fabricating a laser/FET unit or PD/FET unit, there is a problem in how to match the laser structure to the FET structure, as each component has a very different layer structure. A laser generally has a higher structure than an FET. As conventional photolithographic technology requires a wafer with an even surface, the laser may therefore have to be formed in an etched groove.

A known method of producing the above-mentioned prior art OEIC device incorporating a laser/FET unit, also disclosed in the paper concerned, may be considered to comprise the steps of: providing a resist pattern on a main face of a single-crystalline substrate; subjecting the said substrate to an etching process to form a recess; forming a single-crystalline semiconductor layer on the bottom of the said recess; forming an optical semiconductor element, at least part of which is constituted by the said layer, and forming an electronic semiconductor element at a residual portion of the said main face adjacent to the recess; and forming a wiring portion connecting the said optical semiconductor element to the said electronic semiconductor element.

In this method the etching process is a wet chemical etching process. Since in this prior art device the said substrate is a (100)-oriented semi-insulating GaAs substrate, when the chemical etching process in the above-described method is performed on the substrate a (011̅) face is exposed as a side wall, which (011̅) face forms a 55^{o} angle with respect to the (100) top surface, so that a groove having a sharp step is formed. This sharp step can make application of the photolithographic technology difficult. Thus, high integration of the laser/FET unit becomes difficult.

Further, the sharp 55^{o} angle step often results in breakage of wiring and thus a reduced production yield.

It is therefore desirable, in view of the above disadvantages of the prior art, to provide a method of producing a semiconductor device including both optical semiconductor elements, such as a laser diode, and ordinary electronic semiconductor elements, such as an FET, formed on a single substrate, in which the side walls of the recess have a gentle slope (as opposed to the sharp slope of the prior art) so that photolithography can be more readily performed at a desirably high integration density, and wiring can be provided with less danger of breakage.

According to the present invention there is provided a method of producing a semiconductor device, comprising the steps of: providing a resist pattern on a main face of a single-crystalline substrate; subjecting the said substrate to an etching process to form a recess; forming a single-crystalline semiconductor layer on the bottom of the said recess, the top surface of the said semiconductor layer being substantially level with the said main face of the substrate; forming an optical semiconductor element, at least part of which is constituted by the said layer, and forming an electronic semiconductor element at a residual portion of the said main face adjacent to the recess; and forming a wiring portion connecting the said optical semiconductor element to the said electronic semiconductor element; characterised in that the said etching process is a dry etching process, and in that the resist pattern includes an edge-defining portion that overlies a peripheral region of the required recess, the thickness of that portion being caused to increase progressively in the outward direction from the recess, and in that etching is continued until the said edge-defining portion is removed thereby, so that substrate material originally underlying that portion is progressively etched away to leave the said peripheral region sloping gently upwards from the bottom of the recess to the said residual portion of the said main face, the said wiring portion being formed to extend over the said peripheral region of the recess.

Reference will now be made, by way of example, to the accompanying drawings, in which:
Figs. 1A to 1K show cross-sectional views illustrating steps in a method of producing a semiconductor device embodying the present invention;
Figs. 2 and 3 are cross-sectional views, to a larger scale, showing respective parts of the finished device;
Fig. 4 shows a perspective view of the finished device;
Fig. 5 shows a circuit diagram of the device shown in Fig. 4;
Fig. 6A shows a cross-sectional view, corresponding substantially to Fig. 3, but illustrating a modification to the part of the device shown in Fig. 3, and Fig. 6B illustrates a step in a method of producing the modified part of Fig. 6A;
Fig. 7 shows a circuit diagram corresponding to Fig. 6A; Fig. 8 shows a cross-sectional view of another device embodying the present invention;
Fig. 9 shows a perspective view corresponding to Fig. 8;
Fig. 10 shows a circuit diagram of the device shown in Fig. 9;
Fig. 11A and 11B show cross-sectional views illustrating a step in a first modification to the method of Fig. 1;
Figs. 12A and 12B show cross-sectional views illustrating a step in a second modification to the method of Fig. 1; and
Figs. 13A and 13B show cross-sectional views illustrating a step in a third modification to the method of Fig. 1.

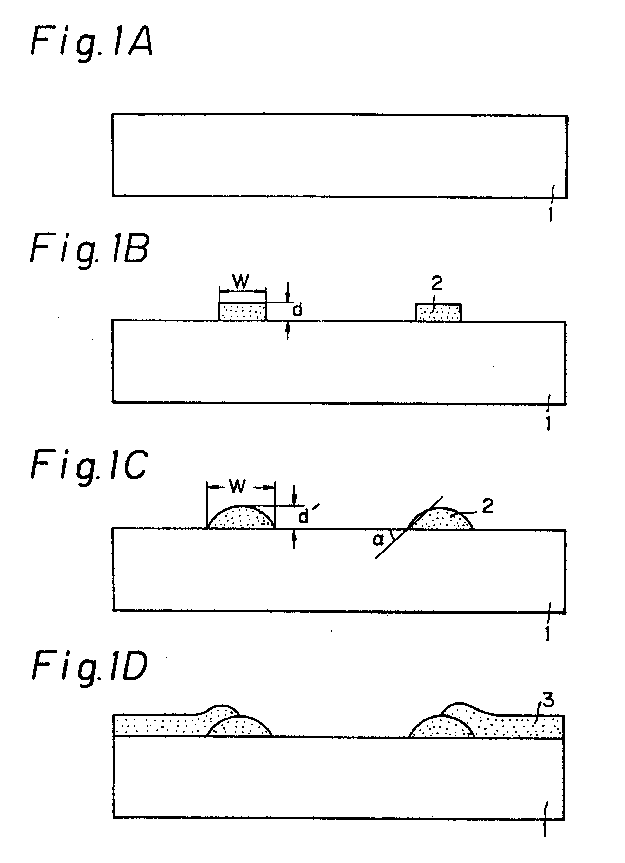

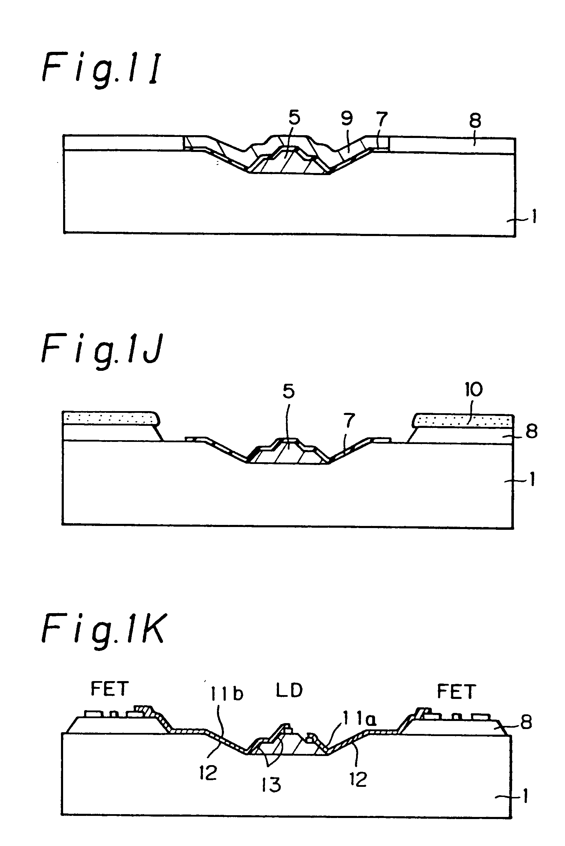

Figs 1A to 1K are cross-sectional views for explaining a method of producing a semiconductor device embodying the present invention.

After providing a GaAs substrate 1 as shown in Fig. 1A, a photo resist 2, for example AZ4620 (produced by Hoechst), having a thickness of 5 to 15µm is formed over the surface of the GaAs substrate 1 and patterned in a stripe form, as shown in Fig. 1B.

The width W of the stripes of the resist layer may be 50 to 200µm, preferably 100µm. And the thickness d may be 7 ∼ 8µm.

Next, as shown in Fig. 1C, heat treatment for baking is carried out for 10 minutes at a temperature of 200^{o}C to change the edges of the resist layer 2 to gentle slopes and increase the thickness d' of the resist layer 2 to about 8 to 10µm. In this heat treatment, the temperature is 200^{o}C which is lower than the usual post baking temperature 120^{o}C. And the width W will not be changed so that the slope α of the edge of the mask 2 is approximately 5^{o} ∼ 15^{o}. The thickness d' of the resist mask should be larger than the total thickness of the semiconductor laser layer which will be formed in a groove (recess) later. There are some rules which decide the slope of the heated mask. Thus, the slope of the edge depends upon the relationship between W and d.

As shown in Fig. 1D, a resist layer 3 is formed over the obtained structure and then patterned. The patterned resist layer 3 has a thickness of 5 to 15µm. Since the resist layer 2 had been heat-treated, it is not removed in the patterning process of the resist layer 3. Thus, the gentle slopes of the resist layer 2 facing the centre Fig. 1D are exposed, while the other slopes are protected by the resist layer 3. A slight heat-treatment is carried out to dry the patterned resist layer 3.

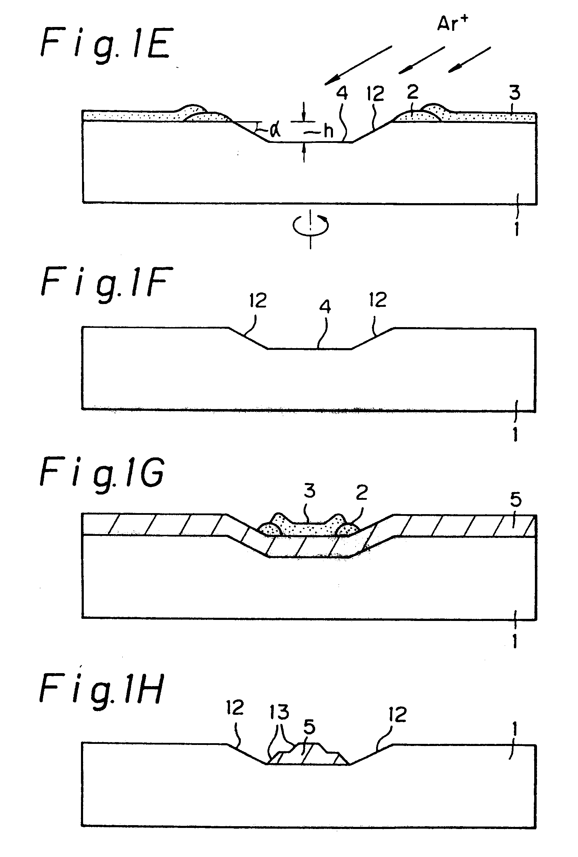

As shown in Fig. 1E, an ion beam etching, for example argon ion (Ar⁺) beam etching, is used to etch a mesa while rotating the GaAs substrate 1. In this ion beam etching process, the ion beam irradiates the GaAs substrate 1 at an angle of about 70^{o}. When the mesa height h is about 10µm, the ion beam etching process is ended. Thus, a groove 4 having a slope 12 at an angle α of about 5^{o} to 15^{o} is formed in the GaAs substrate 1. The ion beam etching conditions are an acceleration voltage of 500 and an ion current density of 0.57 mA/cm².

The ion beam etching process etches all of the exposed surfaces equally, irrespectively of the various materials thereof, so as to remove progressively edge-defining portions of the resist layer 2, and substrate material originally underlying those portions, to leave peripheral regions 12 of the groove 4 sloping gently upwards from the bottom of the groove to residual portions of the main face of the substrate 1. Thus, the initial slope of each edge-defining portion of the mask 2/3 as shown in Figure 1D is shifted downwardly into the etched substrate 1, so that the required groove 4 results as shown schematically in Fig. 1E.

As shown in Fig. 1F, the residual resist layers 2 and 3 are then removed, resulting in the GaAs substrate 1 having a mesa type recess or groove 4 with a gentle slope 12.

As shown in Fig. 1G, a semiconductor laser layer 5 consisting of an n⁺ type GaAs layer, n type Al_{0.3}Ga_{0.7}As layer, etc, is grown over the entire GaAs substrate 1 by molecular-beam epitaxy (MBE). The structure of the layers corresponds to that of the optical semiconductor element, i.e the laser diode LD, or photodiode PD.

As shown in Fig. 1H, the semiconductor laser layer 5 is then patterned using two above-mentioned gentle-slope forming steps (represented schematically by mask 2,3 in Fig. 1G) to form two further slopes 13.

As shown in Fig. 1I an SiO₂ layer 7 is formed over the obtained structure and then patterned so that the SiO₂ layer covers the layer 5 formed in the etched groove. Then an FET epitaxial layer 8 is grown on the substrate while forming a polycrystalline (Al)GaAs layer 9 on the SiO₂ layer 7. The structure of the FET epitaxial layer 8 corresponds to that of a FET the thickness of which is not so large as the semiconductor laser layer 5.

As shown in Fig. 1J, the polycrystalline (Al)GaAs layer 9 is removed by a chemical etching process using a resist layer 10 as a mask. After that, the SiO₂ layer 7 is also etched and the resist layer 10 is removed. Then, various LD and FET electrodes and a wiring layer 11a, 11b are formed on the gentle slope 12 as shown in Fig. 1K.

The reasons for making the gentle slope 12 depend on two main requirements which are necessary for making the OEIC.

Firstly, in order to deposit the wiring layer on the slope between LD and FET, the slope should be gentle because it is quite difficult to deposit a thick enough wiring layer on a sharp slope as used conventionally.

Secondly, in the patterning process of the wiring layer 11a, 11b formed on the entire surface of the substrate, a photo resist layer should be coated on the wiring layer. The thickness of the coating resist layer should be large enough to cover properly even on the sharp slope. This results in the portions of the resist layer coated on the upper surface where the FET's wiring is patterned becoming indesirably thick so that it may be impossible to produce a fine pattern for the FET IC because of the thick resist. In a device as described above embodying the present invention, however, since the slope is gentle, the coating resist can be thin and it is possible to make a fine pattern.

A detailed explanation relating to Fig. 1K will be given below.

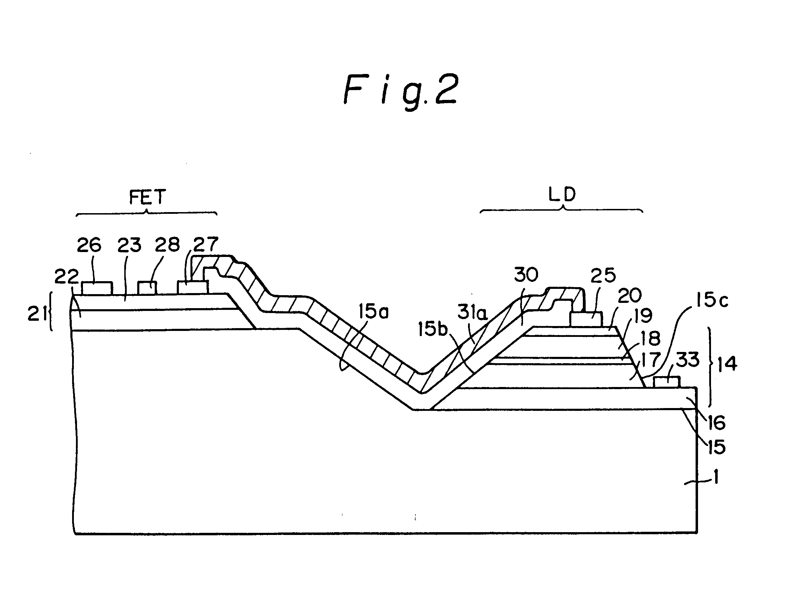

Figure 2 shows a cross-sectional view, to a larger scale, of parts of the device shwon in Fig. 1K. In Fig. 2, reference numeral 1 represents the GaAs substrate, 14 the semiconductor laser layer structure which is multilayer, 15 a recess, 15a, 15b and 15c gentle slopes, 16 an n side contact layer of an n⁺ type GaAs, 17 an n side clad layer of n type Al_{0.3}Ga_{0.7}As, 18 an active layer of either n type or p-type GaAs, 19 a p side clad layer of p type Al_{0.3}Ga_{0.7}As, 20 a p side contact layer of p⁺ type GaAs, 21 an FET layer, 22 an undoped GaAs layer, 23 an n GaAs FET active layer, 25 a p side contact electrode of AuZn, 26 a source electrode of AuGe/Ni, 27 a drain electrode of AuGe/Ni, 28 a gate electrode of Al, 30 an insulating layer of SiO₂ , and 31 a wiring layer of Au/Cr. Although in Fig. 1K there is a step between the two left-hand gentle slopes 13, it is possible not to form such a step and in such a case a single gentle slope 15b may be provided, as shown in Fig. 2.

A method of producing the structure of Fig. 2,in which the p side contact electrode 25 is connected to the drain electrode 27 through the wiring layer formed on the gentle slopes 15a and 15b, will be explained below in detail.

After forming a recess 15 having the gentle slopes 15a as explained above, the n side contact layer 16, the n side clad layer 17, the active layer 18, the p side clad layer 19 and the p side contact layer 20 are successively formed. The multilayer 14 consisting of the n side contact layer 16 to the p side contact layer 20 is patterned by the above-mentioned gentle-slope forming process to form the gentle slope 15b.

Then, the FET layer 21 consisting of the undoped GaAs layer 22 and n GaAs active layer 23 is formed by MBE, as explained above with reference to Figs. 1I, 1J.

The p side contact electrode 25 for the LD is then formed on the p side contact layer 20 by a lift-off process.

After that, the n side contact electrode 33 is formed on the n side contact by a lift-off process and an alloying.

The source electrode 26 and the drain electrode 27 for the FET are also formed on the FET layer 21.

The insulating layer 30 is formed over the obtained structure by a sputtering process and is patterned by photolithography.

A wiring layer 31a is formed on the gentle slope 15a, 15b via the insulating layer 30 by a lift-off process.

Thus, the structure of Fig. 2 can be formed on a single GaAs substrate.

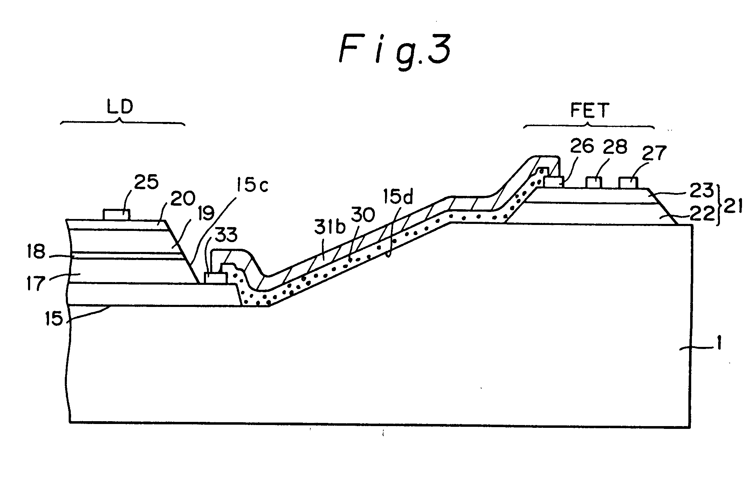

Fig. 3 shows a cross-sectional view, to a larger scale of further parts of the device shown in Fig. 1K. In Fig. 3, the same reference numerals as in Fig. 2 represent the same portions.

As seen in Fig. 3, the source electrode 26 is connected to the n side contact electrode 33 through the wiring 31b formed on the insulator layer 30 overlying the gentle slope 15d.

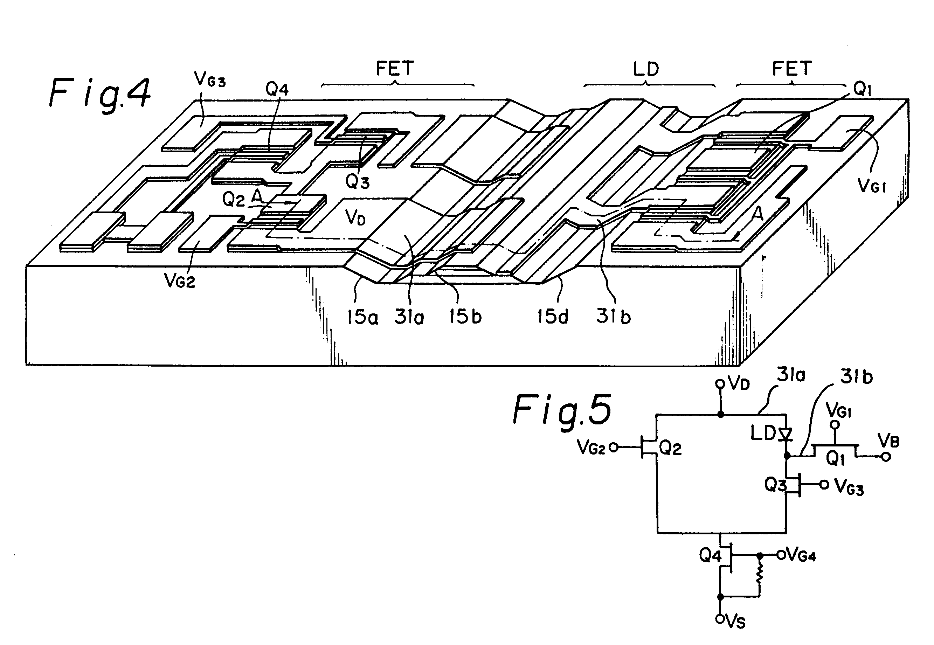

Figure 4 shows a perspective view corresponding to Fig. 1K, Fig. 1K being a cross-sectional view taken along the line AA in Fig. 4.

Figure 5 is a circuit diagram of the device of Fig. 4.

As easily understood from the accordance between the Fig. 4 and Fig. 5, the wiring 31a on the gentle slopes 15a, 15b connects between the LD and the FET Q₂ , and the wiring 31b on the gentle slope 15d connects between the LD and the FET Q₁. In this embodiment, the LD and Q₂ can be connected by the wiring 31a formed within the OEIC itself so that the characteristic of the OEIC is improved.

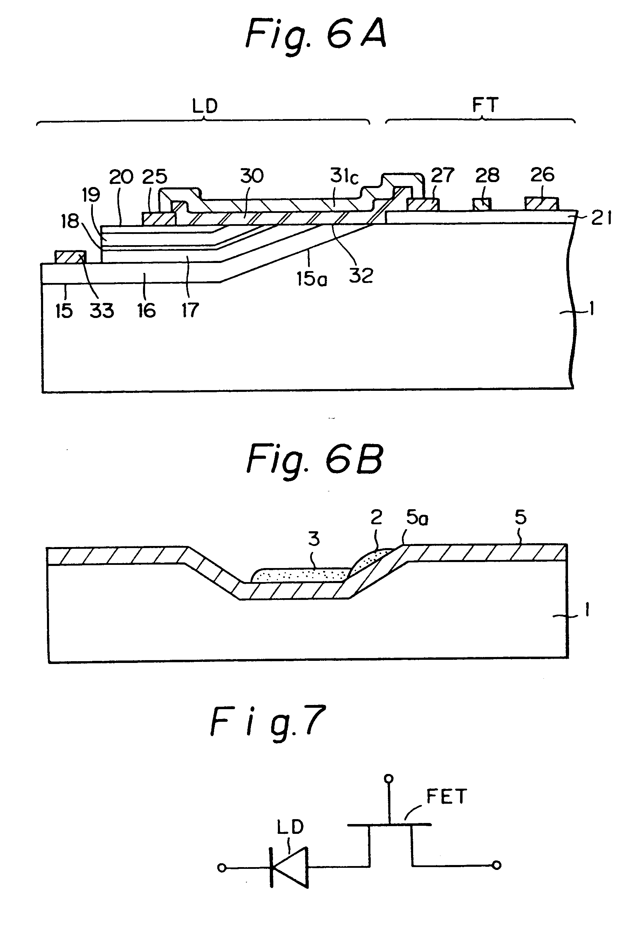

Figure 6A shows a cross-sectional view of parts of another semiconductor device embodying the present invention. In Fig. 6A, the LD and FET are also formed on a GaAs substrate 1. The drain electrode 27 is connected to the p side contact electrode 25 via the wiring 31c formed on a substantially flat surface 32 extending between the electrodes.

The process of producing the Fig. 6A device is almost the same as the process shown in Fig. 1A-1H. That is, as shown in Fig. 6B, after forming the semiconductor laser layer 5, the combination mask 2 and 3 is formed so that the edge of the mask 2,3 corresponds to the slope of the layer 5 (shown 5a). After that the flat surface 32 can be formed on the gentle slope 15a by performing the ion beam etching process as explained above.

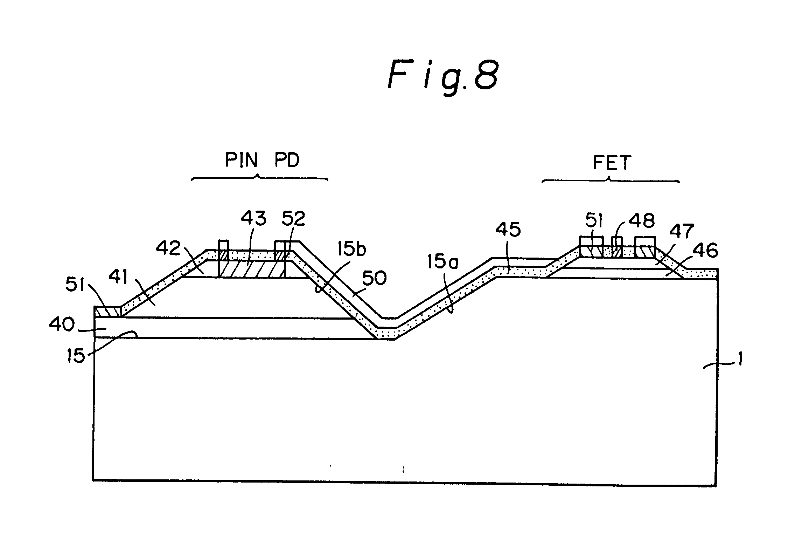

The same reference numerals as in Fig. 2 and 3 represent the same portions. Figure 7 is a schematic circuit diagram of the device of Fig. 6.

Figure 8 shows a cross-sectional view of parts of yet another semiconductor device embodying the present invention. In Fig. 8, a pin photo-diode (PIN PD) and an FET are formed on a single semi-insulating GaAs substrate 1. In Fig. 8, reference numeral 40 is an n⁺ type GaAs layer, 41 an n⁻ type GaAs layer, 42 a high resistivity Al_{0.3}Ga_{0.7}As layer, 43 a Zn diffused region, 45 an Si₃N₄ layer, 46 an undoped GaAs layer, 47 an n type GaAs layer, 48 an Al electrode, 50 a wiring layer of Au/Ti, 51 an Au/AuGe electrode, and 52 an Au/Zn/Au electrode. As shown in Fig. 8, the Al electrode 48 is interconnected to the Au/Zn/Au electrode through an Au/Ti wiring layer 50 continuously laid on the gentle slopes 15a and 15b.

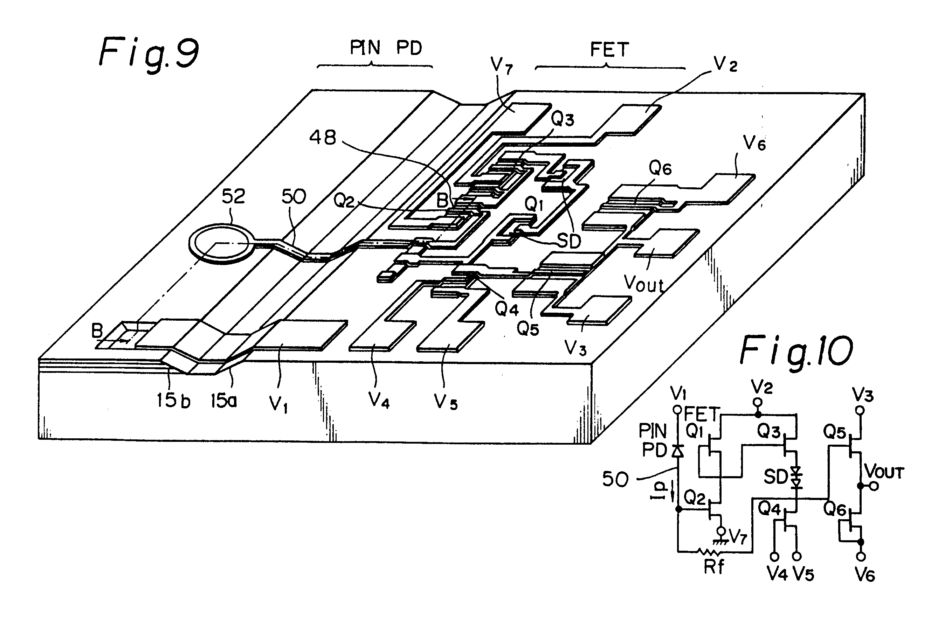

Figure 9 shows a perspective view of the device of Fig. 8 (Fig. 8 presents the view as seen along line B-B in Fig. 9).

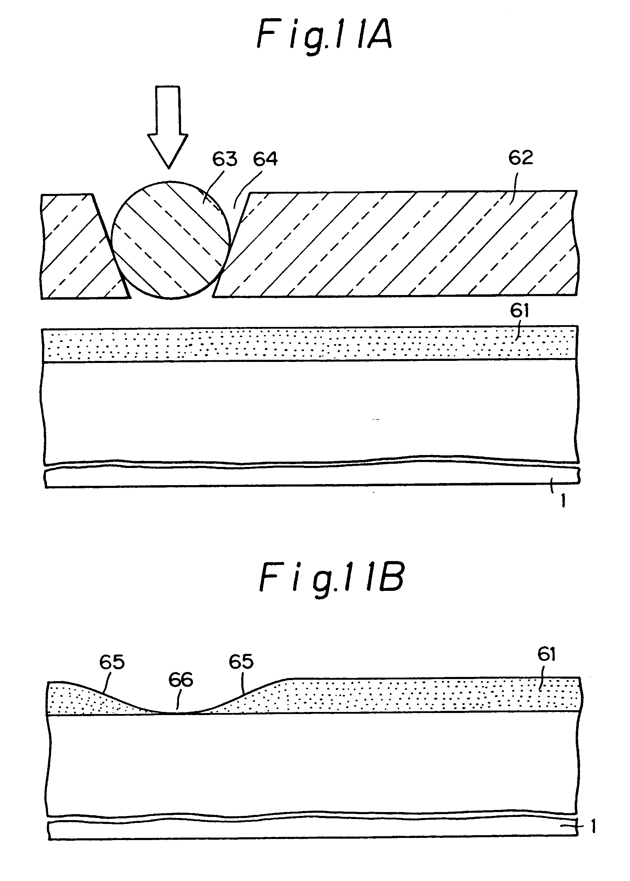

Figure 10 is a circuit diagram of the device of Fig. 9.

Other methods for forming a recess having a gentle slope in a semi-insulating GaAs substrate will now be explained. Figures 11A and 11B show cross-sectional views illustrating different stages of processing in one such method. As shown in Fig. 11A, a resist layer 61 having a thickness of, for example, 6 µm is formed. The resist layer 61 is then exposed through a mask of a photosensitive glass having a hole 64 with a taper wall and a glass fiber 63. The resist layer at the central position just under the glass fibre 63 is most exposed, and the amount of exposure is gradually reduced as the distance from that position on the resist layer increases.

Thus, as shown in Fig. 11B, the resist layer has a pattern 66 having a gentle slope 65.

After that, using ion etching or reactive ion etching, the entire surface of the obtained structure is etched. Thus, a recess having the same pattern 66 can be formed in the semi-insulating GaAs substrate 1.

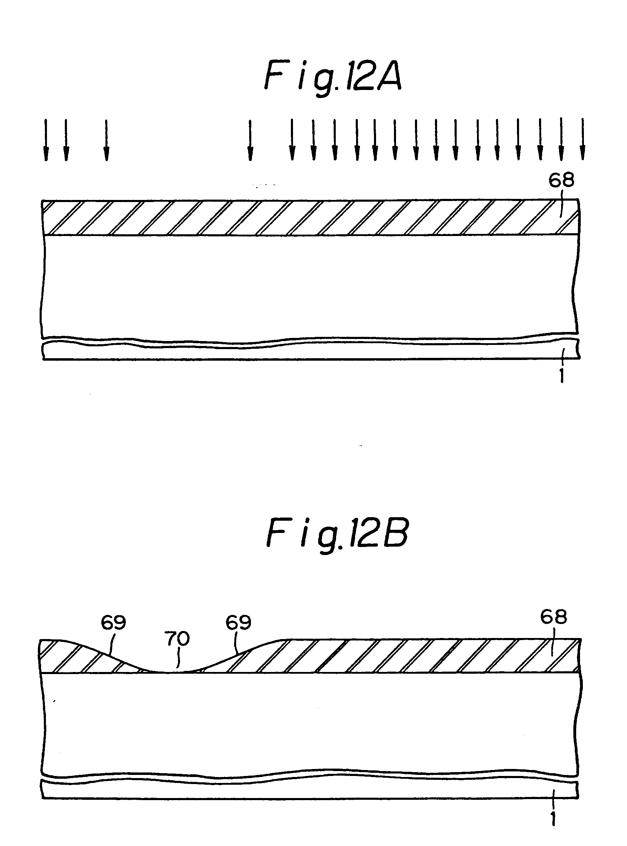

Figures 12A and 12B show cross-sectional views illustrating different stages of processing in another method of forming a gentle slope in a substrate. As shown in Fig. 12A, a polyimide layer having a thickness of, for example, 6 µm is formed on a semi-insulating GaAs substrate 1. The polyimide layer is heated by irradiation with a laser so that a portion of the polyimide in which a recess having a gentle slope is formed is irradiated less compared to the surrounding portion. The center of the recess forming portion may be not irradiated at all. After that, the recess forming process for the semi-insulating GaAs substrate is carried out as explained with Fig. 11B.

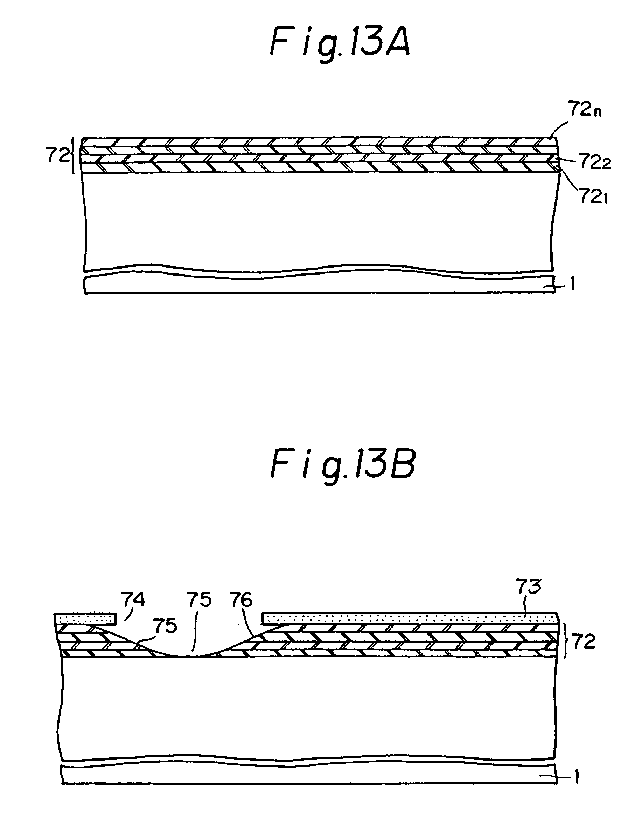

Figures 13A and 13B show cross-sectional views illustrating different stages of processing in yet another method of forming a gentle slope in a substrate. As shown in Fig. 13A, a first polyimide resin layer 72₁ having a thickness of, for example, 6000Å (0.6µm) is formed on a semi-insulating GaAs substrate 1. Then, the first polyimide resin layer 72₁ is heat-treated at a first temperature T₁ of, for example, 200°C. A second polyimide resin layer 72₂ is formed on the first polyimide resin layer 72₁ and is heat-treated at a second temperature T₂ of, for example, 180°C, which is lower than the first temperature T₁. The process is repeated until the nth polyimide layer is formed on the (n-1)th polyimide layer and is heat-treated at a temperature Tₙ lower than temperature Tₙ₋₁. Thus, a polyimide resin multi-layer 72 is formed on the semi-insulating GaAs substrate. When a polyimide resin is heat-treated at a higher temperature, the etching rate is decreased.

Then, as shown in Fig. 13B the polyimide resin multilayer 72 is etched by an etchant, using a resist layer 73 having an opening 74 as a mask so that a recess 75 having a gentle slope 76 is formed in the polyimide multilayer 72. Then, the recess forming process as explained in Fig. 11B. is carried out for the semi-insulating GaAs substrate.

Furthermore, in a further method, also explained with reference to Figs. 13A and 13B, the multi-layer 72₁, 72₂ ... 72ₙ comprises AlₓGa₁₋ₓAs layers in which the value of x is gradually increased from 72₁ to 72ₙ. Then, the wet etching process using a etchant containing HF is performed so that since the AlGaAs is etched faster than the GaAs or AlGaAs having a small quantity of Al, the etched pattern becomes shown in Fig. 13B having a gentle slope 76. After that, there are two alternative processes. The first process is that the ion beam etching is simply performed in the same manner as the previous explained process. The second process is that since the multi-layer 72 comprises a AlGaAs compound semiconductor, the FET structure is formed on or in the multi-layer 72.

## Claims

1. A method of producing a semiconductor device, comprising the steps of:
providing a resist pattern (2, 3) on a main face of a single-crystalline substrate (1);
subjecting the said substrate (1) to an etching process to form a recess (4);
forming a single-crystalline semiconductor layer (5) on the bottom of the said recess (4), the top surface of the said semiconductor layer (5) being substantially level with the said main face of the substrate (1);
forming an optical semiconductor element (LD), at least part of which is constituted by the said layer (5), and forming an electronic semiconductor element (FET) at a residual portion of the said main face adjacent to the said recess; and
forming a wiring portion (11b) connecting the said optical semiconductor element (LD) to the said electronic semiconductor element (FET);
characterised in that the said etching process is a dry etching process, and in that the said resist pattern (2, 3) includes an edge-defining portion that overlies a peripheral region of the required recess (4), the thickness of that portion being caused to increase progressively in the outward direction from the recess, and in that etching is continued until the said edge-defining portion is removed thereby, so that substrate material originally underlying that portion is progressively etched away to leave the said peripheral region (12) sloping gently upwards from the bottom of the recess to the said residual portion of the said main face, the said wiring portion (11b) being formed to extend over the said peripheral region of the recess.

2. A method as claimed in claim 1, wherein the said single-crystalline substrate is made of semi-insulating GaAs.

3. A method as claimed in claim 1 or 2, wherein the said resist pattern (2, 3) is provided by forming a first resist layer on the said main face of the substrate (1), which layer includes a strip (2) that extends over the said peripheral region of the required recess, and by subjecting the said first resist layer to a heat-treatment to cause the edges of the strip (2) to become rounded, and by forming a second resist layer (3), extending over the said first resist layer, and patterning that second resist layer (3) to leave the said resist pattern, the said resist pattern (2, 3) being such that an exposed rounded edge part of the said strip, not covered by the said second resist layer (3), provides the said edge-defining portion.

4. A method as claimed in claim 1 or 2, wherein the said resist pattern is provided by forming a resist layer (61) on the said main face of the substrate (1), and by exposing a selected portion of that layer (61), overlying the said peripheral region of the required recess (4), to light received via a mask (62), the mask having light transmission properties such that the amount of light received at the said selected portion decreases progressively in the outward direction from the required recess (4), and by developing the said resist layer (61) to leave the said resist pattern, the said edge-defining portion (65) being constituted by a residual portion of the said selected portion.

5. A method as claimed in claim 4, wherein the said mask (62) comprises a sheet of photo-sensitive glass having therein a tapered hole (64) in which an optical fibre (63) is arranged.

6. A method as claimed in claim 1 or 2, wherein the said resist pattern is provided by forming a polyimide resin resist layer (68) on the said substrate, and by subjecting that layer to a heat-treatment such that the heat applied to a selected portion of the layer, which portion overlies the said peripheral region of the required recess (4), increases progressively in the outward direction from the required recess, and by developing the heat-treated resist layer (68) to leave the said resist-pattern, the said edge-defining portion (69) being constituted by a residual portion of the said selected portion.

7. A method as claimed in claim 1 or 2, wherein the said resist pattern is provided by forming a first polyimide resin layer (72₁) on the said main face of the substrate and by subjecting that layer (72₁) to a heat-treatment at a first temperature, and by forming a second polyimide resin resist layer (72₂) on the first resist layer (72₁) and subjecting that second resist layer to a heat-treatment at a second temperature, lower than the said first temperature, and by forming at least one further such resist layer (72ₙ) over the last preceding resist layer (72ₙ₋₁) and heat-treating that further layer (72ₙ) at a temperature lower than that at which the last preceding resist layer (72ₙ₋₁) was heat-treated, and by patterning the resulting layer structure (72) using a mask (73) having an opening (74) corresponding to the said region of the said main face that is to be etched away to form the recess.

8. A method as claimed in any preceding claim, wherein the said optical semiconductor element (LD) comprises a plurality of semiconductor layers (17, 18, 19, 20) formed as a stack on the said single-crystalline semiconductor layer (16), which method includes the steps of:
forming on the top layer (20) of the said stack (17-20) a further resist pattern, which pattern is formed to delimit parts of the said stack that are to be etched away by a further etching process and includes a further edge-defining portion the thickness of which decreases progressively in the said outward direction from the recess; and
performing the said further etching process, wherein etching is continued until the said further edge-defining portion is removed thereby, so that material of the said stack originally underlying the said further edge-defining portion is progressively etched away to leave a wiring support region (15b) of the said stack sloping gently downwards into the said recess from a remaining portion of the said top layer (20) and facing the said peripheral region of the recess;
the said wiring portion (31a) being formed to extend also over the said wiring support region (15b).

9. A method as claimed in any preceding claim, wherein the said dry etching process is an ion beam etching process.

10. A method as claimed in any one of claims 1 to 8, wherein the said dry etching process is a reactive ion etching process.

11. A method as claimed in any preceding claim, wherein the said optical semiconductor element is a laser diode (LD).

12. A method as claimed in any one of claims 1 to 10, wherein the said optical semiconductor element is a photodiode.

13. A method as claimed in any preceding claim, wherein the said electronic semiconductor element is a field effect transistor (FET).

## Patentansprüche

1. Verfahren zur Herstellung eines Halbleiterbauelements, umfassend die Schritte: Vorsehen einer Resiststruktur (2, 3) auf der Hauptfläche eines Einkristallsubstrats (1);
Unterwerfen des Substrats (1) einem Ätzvorgang, so daß ein Graben (4) ausgebildet wird;
Erzeugen einer Einkristall-Halbleiterschicht (5) auf der Sohle des Grabens (4), wobei die Oberseite der Halbleiterschicht (5) mit der Hauptfläche des Substrat (1) im wesentlichen abschließt;
Erzeugen eines optischen Halbleiterelements (LD), das zumindest teilweise von der Schicht (5) gebildet ist, sowie eines elektronischen Halbleiterelements (FET) auf einem verbliebenen Abschnitt der Hauptfläche in Nachbarschaft zum Graben (4); und
Erzeugen eines Leiterabschnitts (11b), der das optische Halbleiterelement (LD) mit dem elektronischen Halbleiterelement (FET) verbindet;
**dadurch gekennzeichnet**, daß der Ätzvorgang ein Trockenätzverfahren ist;
daß die Resiststruktur (2, 3) einen Kanten definierenden Abschnitt aufweist, der den Randbereich des notwendigen Grabens (4) abdeckt, wobei die Dicke dieses Abschnitt vom Graben nach außen hin stetig zunehmend gehalten wird;
daß das Ätzen solange erfolgt, bis der Kanten definierende Abschnitt entfernt ist, so daß das ursprünglich unter diesem Abschnitt liegende Substratmaterial zunehmend abgeätzt wird und der Randbereich (12) von der Sohle des Grabens zum verbliebenen Abschnitt der Hauptfläche sanft ansteigt, wobei der Leiterabschnitt (11b) über den Randbereich (12) des Grabens (4) erstreckend ausgebildet wird.

2. Verfahren nach Anspruch 1, wobei das Einkristall-Substrat (1) aus halbisolierendem GaAs besteht.

3. Verfahren nach Anspruch 1 oder 2, wobei die Resiststruktur (2, 3) so erzeugt wird, daß auf die Hauptfläche des Substrats (1) eine erste Resistschicht aufgetragen wird, die einen über den Randbereich des Grabens (4) hinweggehenden Streifen (2) enthält;
daß die erste Resistschicht (2), um die Kanten des Streifens (2) zu runden, einer thermischen Behandlung unterzogen wird;
daß eine zweite Resistschicht (3), erstreckend über die erste Resistschicht (2), aufgebracht wird;
daß die zweite Resistschicht (3) strukturiert wird, wobei eine Resiststruktur (2, 3) zurückbleibt, so daß ein freigelegtes gerundetes Kantenteil des Streifens, der von der zweiten Resistschicht (3) nicht bedeckt wird, den Kanten definierenden Abschnitt stellt.

4. Verfahren nach Anspruch 1 oder 2, wobei die Resiststruktur erzeugt wird durch Aufbringen einer Resistschicht (61) auf die Hauptfläche des Substrats (1); durch Belichten eines ausgewählten Abschnitts dieser über den Randbereich des Grabens (4) gehenden Schicht (61) durch die Maske (62); wobei die Lichtdurchlässigkeit der Maske so ist, daß die im ausgewählten Abschnitt durchgelassene Lichtmenge - vom Graben (4) aus gesehen - nach außen abnimmt; sowie durch Entwickeln der Resistschicht (61), damit eine Resiststruktur (2, 3) erhalten wird, wo der Kanten definierende Abschnitt (65) von einem verbliebenen Teilstück des ausgewählten Abschnitts gebildet wird.

5. Verfahren nach Anspruch 4, wobei die Maske (62) ein lichtempfindliches Glas mit einer konischen Öffnung (64), in der eine optische Faser (63) angebracht ist, umfaßt.

6. Verfahren nach Anspruch 1 oder 2, wobei die Resiststruktur erzeugt wird durch
Aufbringen einer Polyimidharz-Resistschicht (68) auf das Substrat;
Wärmebehandeln der Schicht (68), wobei die Wärme so auf den gewählten Schichtabschnitt, der den Randbereich des Grabens überdeckt, appliziert wird, daß sie vom Graben weg stetig zunimmt; und
Entwickeln der wärmebehandelten Resistschicht (68), damit eine Resiststruktur bleibt - damit ein Kanten definierender Abschnitt (69), der vom verbliebenen Teilabschnitt des ausgewählten Abschnitts gestellt wird, bleibt.

7. Verfahren nach Anspruch 1 oder 2, wobei die Resiststruktur (2, 3) erzeugt wird durch:
Aufbringen einer ersten Polyimidharz-Resistschicht (72₁) auf die Hauptfläche des Substrats (1);
thermisches Behandeln dieser Schicht (72₁) bei einer ersten Temperatur;
Aufbringen einer zweiten Polyimidharz-Resistschicht (72₂) auf die erste Resist-Schicht (72₁);
thermisches Behandeln der zweiten Resistschicht (72₂) bei einer unter der ersten Temperatur liegenden zweiten Temperatur;
Aufbringen mindestens einer weiteren Resistschicht (72ₙ) auf die letzte vorhergehende Resistschicht (72ₙ₋₁);
thermisches Behandeln dieser weiteren Schicht (72ₙ) bei einer unter der Behandlungstemperatur der vorhergehenden Schicht (72ₙ₋₁) liegenden Temperatur; sowie
Strukturieren der erhaltenen Schichtstruktur (72) unter einer Maske (73) mit einer Öffnung (74), die dem Bereich der Hauptfläche entspricht, die zur Ausbildung des Grabens (75) wegzuätzen ist.

8. Verfahren nach einem der vorhergehenden Ansprüche, wobei das optische Halbleiterelement (LD) aus einer Vielzahl Halbleiterschichten (17, 18, 19, 20), die auf der Einkristall-Halbleiterschicht (16) gestapelt sind, besteht und das Verfahren folgende Schritte umfaßt:
Aufbringen einer weiteren Resiststruktur auf die oberste Schicht (20) des Stapels (17-20), wobei die Struktur zur Abgrenzung der in einem weiteren Ätzschritt wegzuätzenden Abschnitte des Stapels dient und ferner einen Kanten definierenden Abschnitt enthält, dessen Dicke vom Graben (15) nach nach außen nach und nach abnimmt; sowie
Durchführen eines weiteren Ätzschritts, wobei das Ätzen solange durchgeführt wird, bis der weitere Kanten definierende Abschnitt entfernt ist, so daß das unter dem weiteren Kanten definierenden Abschnitt liegende Material des Stapels nach und nach abgeätzt wird, damit vom Stapel ein Leitungsträgerbereich (15b) bleibt, der vom verbliebenen Teilstück der obersten Schicht (20) eine leicht geneigte Flanke bis zum Graben ausbildet und dem Randbereich des Grabens zugewandt ist; wobei der Leitungsabschnitt (31a) auch über den Leitungsträgerbereich (15b) gehend geformt wird.

9. Verfahren nach einem der vorhergehenden Ansprüche, wobei das Trockenätzverfahren ein Ionenstrahl-Ätzverfahren ist.

10. Verfahren nach einem der Ansprüche 1 bis 8, wobei das Trockenätzverfahren ein Ätzverfahren mit reagierenden Ionen ist.

11. Verfahren nach einem der vorhergehenden Ansprüche, wobei das optische Halbleiterelement eine Laserdiode (LD) ist.

12. Verfahren nach einem der Ansprüche 1 bis 10, wobei das optische Halbleiterelemente eine Photodiode ist.

13. Verfahren nach einem der vorhergehenden Ansprüche, wobei das elektronische Halbleiterelement ein Feldeffekttransistor (FET) ist

## Revendications

1. Procédé de fabrication d'un dispositif à semiconducteur, comprenant les étapes de :
production d'un motif de réserve (2, 3) sur une face principale d'un substrat monocristallin (1) ;
soumission dudit substrat (1) à un processus de gravure pour former un évidement (4) ;
formation d'une couche semiconductrice monocristalline (5) sur le fond dudit évidement (4), la surface supérieure de la dite couche semiconductrice (5) étant sensiblement à niveau avec ladite face principale du substrat (1) ;
formation d'un élément semiconducteur optique (LD) dont au moins une partie est constituée par ladite couche (5) et formation d'un élément semiconducteur électronique (FET) en une partie résiduelle de ladite face principale adjacente audit évidement ; et
formation d'une partie de câblage (11b) qui connecte ledit élément semiconducteur optique (LD) audit élément semiconducteur électronique (FET),
caractérisé en ce que ledit processus de gravure est un processus de gravure sèche et en ce que ledit motif de réserve (2, 3) inclut une partie de définition de bord qui recouvre une région périphérique de l'évidement requis (4), l'épaisseur de cette partie étant amenée à augmenter progressivement suivant la direction qui va vers l'extérieur depuis l'évidement et en ce qu'une gravure est poursuivie jusqu'à ce que ladite partie de définition de bord soit ainsi ôtée de telle sorte qu'un matériau de substrat originellement sous-jacent à cette partie soit progressivement ôté par gravure pour laisser ladite région périphérique (12) en pente douce vers le haut depuis le fond de l'évidement jusqu'à ladite partie résiduelle de ladite face principale, ladite partie de câblage (11b) étant formée de manière à s'étendre sur ladite région périphérique de l'évidement.

2. Procédé selon la revendication 1, dans lequel ledit substrat monocristallin est constitué par du GaAs semi-isolant.

3. Procédé selon la revendication 1 ou 2, dans lequel ledit motif de réserve (2, 3) est produit au moyen de la formation d'une première couche de réserve sur ladite face principale du substrat (1), laquelle couche inclut une bande (2) qui s'étend sur ladite région périphérique de l'évidement requis, et au moyen de la soumission de ladite première couche de réserve à un traitement thermique pour faire en sorte que les bords de la bande (2) deviennent arrondis ainsi qu'au moyen de la formation d'une seconde couche de réserve (3) s'étendant sur ladite première couche de réserve et de la conformation de cette seconde couche de réserve (3) pour laisser ledit motif de réserve, ledit motif de réserve (2, 3) étant tel qu'une partie de bord arrondi exposée de ladite bande non recouverte par ladite seconde couche de réserve (3) produise ladite partie de définition de bord.

4. Procédé selon la revendication 1 ou 2, dans lequel ledit motif de réserve est produit au moyen de la formation d'une couche de réserve (61) sur ladite face principale du substrat (1) et au moyen de l'exposition d'une partie sélectionnée de cette couche (61) qui recouvre ladite partie périphérique de l'évidement requis (4) à une lumière reçue via un masque (62), le masque présentant des propriétés de transmission de lumière qui sont telles que la quantité de lumière reçue en ladite partie sélectionnée diminue progressivement suivant la direction dirigée vers l'extérieur depuis l'évidement requis (4), ainsi qu'au moyen du développement de ladite couche de réserve (61) pour laisser ledit motif de réserve, ladite partie de définition de bord (65) étant constituée par une partie résiduelle de ladite partie sélectionnée.

5. Procédé selon la revendication 4, dans lequel ledit masque (62) comprend une feuille de verre photosensible comportant en son sein un trou à flancs évasés (64) dans lequel une fibre optique (63) est agencée.

6. Procédé selon la revendication 1 ou 2, dans lequel ledit motif de réserve est produit au moyen de la formation d'une couche de réserve en résine polyimide (68) sur ledit substrat et au moyen de la soumission de cette couche à un traitement thermique de telle sorte que de la chaleur qui est appliquée à une partie sélectionnée de la couche, laquelle partie recouvre ladite région périphérique de l'évidement requis (4), augmente progressivement suivant la direction dirigée vers l'extérieur depuis l'évidement requis, et au moyen d'un développement de la couche de réserve traitée thermiquement (68) pour laisser ledit motif de réserve, ladite partie de définition de bord (69) étant constituée par une partie résiduelle de ladite partie sélectionnée.

7. Procédé selon la revendication 1 ou 2, dans lequel ledit motif de réserve est produit au moyen de la formation d'une couche de réserve en résine polyimide (72₁) sur ladite face principale du substrat, au moyen de la soumission de cette couche (72₁) à un traitement thermique à une première température, au moyen de la formation d'une seconde couche de réserve en résine polyimide (72₂) sur la première couche de réserve (72₁), au moyen de la soumission de cette seconde couche de réserve à un traitement thermique à une seconde température inférieure à ladite première température, au moyen de la formation d'au moins une autre couche de réserve (72ₙ) sur la dernière couche de réserve précédente (72ₙ₋₁), au moyen d'un traitement thermique de cette autre couche (72ₙ) à une température inférieure à celle à laquelle la dernière couche de réserve précédente (72ₙ₋₁) a été traitée thermiquement et au moyen de la conformation de la structure de couche résultante (72) en utilisant un masque (73) comportant une ouverture (74) correspondant à ladite région de ladite face principale qui doit être ôtée par gravure afin de former l'évidement.

8. Procédé selon l'une quelconque des revendications précédentes, dans lequel ledit élément semiconducteur optique (LD) comprend une pluralité de couches semiconductrices (17, 18, 19, 20) formées en tant que pile sur ladite couche semiconductrice monocristalline (16), lequel procédé inclut les étapes de :
formation sur la couche supérieure (20) de ladite pile (17-20) d'un autre motif de réserve, lequel motif est formé afin de délimiter des parties de ladite pile qui doivent être ôtées par gravure au moyen d'un autre processus de gravure et inclut une autre partie de définition de bord dont l'épaisseur diminue progressivement suivant ladite direction dirigée vers l'extérieur depuis l'évidement ; et
réalisation dudit autre processus de gravure dans lequel une gravure est poursuivie jusqu'à ce que ladite autre partie de définition de bord soit ainsi ôtée de telle sorte que du matériau de ladite pile originellement sous-jacente par rapport à ladite autre partie de définition de bord soit progressivement ôté par gravure pour laisser une région de support de câblage (15b) de ladite pile en pente douce vers le bas à l'intérieur dudit évidement depuis une partie restante de ladite couche supérieure (20), cette pente faisant face à ladite région périphérique de l'évidement ;
ladite partie de câblage (31a) étant formée de manière à s'étendre également sur ladite région de support de câblage (15b).

9. Procédé selon l'une quelconque des revendications précédentes, dans lequel ledit processus de gravure sèche est un processus de gravure par faisceau ionique.

10. Procédé selon l'une quelconque des revendications 1 à 8, dans lequel ledit processus de gravure sèche est un processus de gravure ionique réactive.

11. Procédé selon l'une quelconque des revendications précédentes, dans lequel ledit élément semiconducteur optique est une diode laser (LD).

12. Procédé selon l'une quelconque des revendications 1 à 10, dans lequel ledit élément semiconducteur optique est une photodiode.

13. Procédé selon l'une quelconque des revendications précédentes, dans lequel ledit élément semiconducteur électronique est un transistor à effet de champ (FET).
